# EUROPEAN PATENT APPLICATION

(11) **EP 4 421 807 A1**
(43) Date of publication of application: **28.08.2024**
(21) Application number: 24156483.0
(22) Date of filing: 08.02.2024
(51) Int. Cl.: G11C 5/04, H01L 23/00

(54) **BUMP STRUCTURE AND FABRICATION METHOD THEREOF**

(30) Priority: 23.02.2023 US 202363486484 P; 21.01.2024 US 202418418320
(71) Applicant: MediaTek Inc., Hsin-Chu 300 (TW)
(72) Inventor: TSAI, Hung-Pin, 30078 Hsinchu City (TW); TSAO, Pei-Haw, 30078 Hsinchu City (TW); LIU, Nai-Wei, 30078 Hsinchu City (TW); HSU, Wen-Sung, 30078 Hsinchu City (TW)
(74) Representative: Hoefer & Partner Patentanwälte mbB

(57) **Abstract**

A bump structure (1) includes a conductive pad (101) on a semiconductor die (100); a passivation layer (106) covering a perimeter of the conductive pad (101); and a first polymer layer (110) on the passivation layer (106). The first polymer layer (110) includes a via opening (110t) partially exposing the central portion of the conductive pad (101). ARDL (210) is disposed on the first polymer layer (110) and patterned into a bump pad (210p) situated directly above the conductive pad (101). The via opening (110t) is completely filled with the RDL (210) and a RDL via (210v) is integrally formed with the bump pad (210p). A second polymer layer (120) is disposed on the first polymer layer (110). An island (120i) of the second polymer layer (120) is disposed at a central portion of the bump pad (210p). UBM layer (220) is disposed on the bump pad (210p). The UBM layer (220) covers the island (120i) and forms a bulge (220b) thereon. A bump (250) is disposed on the UBM layer (220).

## Description

### Cross Reference to Related Applications

This application claims the benefit of U.S. Provisional Application No. 63/486,484, filed on February 23rd, 2023. The content of the application is incorporated herein by reference.

### Background

The present disclosure relates generally to the field of semiconductor technology, and more particularly, to an improved bump structure of a semiconductor device and a method of manufacturing the bump structure.

With the increasing market demands of electric products for smaller, thinner, faster, and cost-effectiveness, the wafer-level chip-scale package (WLCSP) is the perfect solution and has already proven in a number of electron applications.

The wafer level chip scale package (WLCSP) is a variant of the flip-chip interconnection technique where all packaging is done at the wafer level. With WLCSPs, the active side of the die is inverted and connected to the printed circuit board (PCB) using solder balls. For a mobile application, reliability issues must be fulfilled for example, drop, bending, thermal shock etc.

Drop impact usually induces failures at solder joints since different flex of PCB and chip during drop impact applies stress to solder joints. Stress concentration at solder joint has been a major interest in board level reliability (BLR) evaluation. The solder joint stress during BLR tests are highly related to the structure and solder ball alloy used in WLP bumping process.

### Summary

One object of the present invention is to provide an improved bump structure of a semiconductor device in order to solve the prior art deficiencies or shortcomings. A bump structure and a method for forming a bump structure according to the invention are defined in the independent claims. The dependent claims define preferred embodiments thereof.

One aspect of the invention provides a bump structure including a conductive pad disposed on an active top surface of a semiconductor die; a passivation layer covering a perimeter of the conductive pad, wherein the passivation layer comprises an opening exposing a central portion of the conductive pad; a first polymer layer disposed on the passivation layer and in the opening, wherein the first polymer layer comprises a via opening partially exposing the central portion of the conductive pad; a re-distribution layer (RDL) disposed on the first polymer layer and patterned into a bump pad situated directly above the conductive pad, wherein the via opening is completely filled with the RDL and a RDL via is integrally formed with the bump pad; a second polymer layer disposed on the first polymer layer, wherein the second polymer layer covers a perimeter of the bump pad; an island of the second polymer layer disposed at a central portion of the bump pad; an under-bump metallization (UBM) layer disposed on the bump pad, wherein the UBM layer covers the island and forms a bulge thereon; and a bump disposed on the UBM layer.

Preferably, the conductive pad comprises an aluminum pad.

Preferably, the passivation layer comprises a silicon nitride layer.

Preferably, the first polymer layer comprises polyimide, PBO, phenolic resins, or epoxy resins.

Preferably, the second polymer layer comprises polyimide, PBO, phenolic resins, or epoxy resins.

Preferably, the RDL comprises copper.

Preferably, the RDL via has a width that is smaller than a width of the conductive pad.

Preferably, the island of the second polymer layer is disposed directly above the RDL via and the conductive pad.

Preferably, the island of the second polymer layer has a width that is greater than a width of the RDL via.

Preferably, the island of the second polymer layer has a width that is smaller than a width of the conductive pad.

Preferably, the UBM layer is a multi-layer stack comprising an adhesion layer on the bump pad, a barrier layer on the adhesion layer, and a seed layer on the barrier layer.

Preferably, the bump comprises Sn, Al, Ni, Au, Ag, Pb, Bi, Cu, solder, or any combinations thereof.

Another aspect of the invention provides a method for forming a bump structure. A conductive pad is formed on an active top surface of a semiconductor die. A passivation layer is formed to cover a perimeter of the conductive pad. The passivation layer includes an opening exposing a central portion of the conductive pad. A first polymer layer is formed on the passivation layer and in the opening. The first polymer layer includes a via opening that partially exposes the central portion of the conductive pad. Are-distribution layer (RDL) is formed on the first polymer layer and patterned into a bump pad situated directly above the conductive pad. The via opening is completely filled with the RDL and a RDL via is integrally formed with the bump pad. A second polymer layer is formed on the first polymer layer. The second polymer layer covers a perimeter of the bump pad. An island of the second polymer layer is formed at a central portion of the bump pad. An under-bump metallization (UBM) layer is formed on the bump pad. The UBM layer covers the island and forms a bulge thereon. A bump is formed on the UBM layer.

Preferably, the conductive pad comprises an aluminum pad.

Preferably, the passivation layer comprises a silicon nitride layer.

Preferably, the first polymer layer comprises polyimide, PBO, phenolic resins, or epoxy resins.

Preferably, the second polymer layer comprises polyimide, PBO, phenolic resins, or epoxy resins.

Preferably, the RDL comprises copper.

Preferably, the RDL via has a width that is smaller than a width of the conductive pad.

Preferably, the island of the second polymer layer is disposed directly above the RDL via and the conductive pad.

Preferably, the island of the second polymer layer has a width that is greater than a width of the RDL via.

Preferably, the island of the second polymer layer has a width that is smaller than a width of the conductive pad.

Preferably, the UBM layer is a multi-layer stack comprising an adhesion layer on the bump pad, a barrier layer on the adhesion layer, and a seed layer on the barrier layer.

Preferably, the bump comprises Sn, Al, Ni, Au, Ag, Pb, Bi, Cu, solder, or any combinations thereof.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary bump structure of a semiconductor device in accordance with one embodiment of the invention; and
FIG. 2 to FIG. 5 are schematic, cross-sectional diagrams showing an exemplary method for manufacturing the bump structure in FIG. 1.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

The present disclosure pertains to a direct bump structure of a semiconductor device, which uses four-layer structure including: Polymer-1 (PM1), Redistribution metal (RDL), Polymer-2 (PM2), and under bump metallization (UBM). The bump is stacked directly on the RDL via and a stress buffer of PM2 is disposed under the bump to relieve the stress at the interface between the aluminum pad and the RDL via.

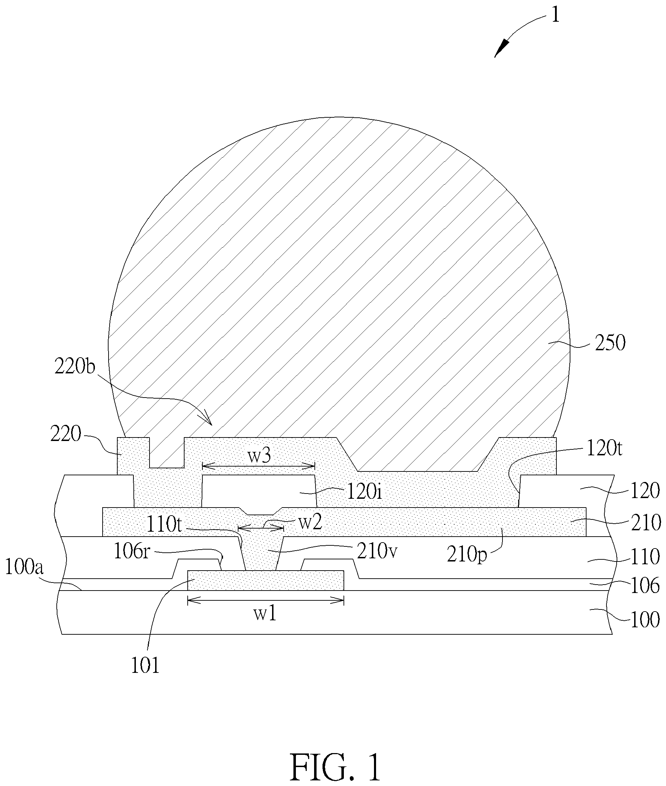

Please refer to FIG. 1, which is a schematic, cross-sectional diagram showing an exemplary bump structure of a semiconductor device in accordance with one embodiment of the invention. As shown in FIG. 1, the bump structure 1 comprises a conductive pad 101 disposed on an active top surface 100a of a semiconductor die 100. Preferably, the conductive pad 101 may comprise an aluminum pad, but is not limited thereto. Preferably, the perimeter of the conductive pad 101 is covered with a passivation layer 106. Preferably, for example, the passivation layer 106 may comprise a silicon nitride layer, but is not limited thereto. An opening 106r is formed in the passivation layer 106 to expose a central portion of the conductive pad 101.

Preferably, a first polymer layer 110 is formed on the passivation layer 106 and in the opening 106r. Preferably, for example, the first polymer layer 110 may comprise polyimide, PBO, phenolic resins, epoxy resins, or any suitable material having similar insulating and structural properties. Preferably, a via opening 110t is formed in the first polymer layer 110. The via opening 110t may have a width that is smaller than a width of the opening 106r. The via opening 110t partially exposes the central portion of the conductive pad 101.

Preferably, a re-distribution layer (RDL) 210 is formed on the first polymer layer 110 and is patterned into a bump pad 210p situated directly above the conductive pad 101. Preferably, the via opening 110t is completely filled with the RDL 210 and a RDL via 210v is integrally formed with the bump pad 210p. Preferably, for example, the RDL 210 may comprise copper. Preferably, the RDL via 210v has a width w2 that is smaller than a width w1 of the conductive pad 101.

Preferably, a second polymer layer 120 is formed on the first polymer layer 110 and covers the perimeter of the bump pad 210p. An opening 120t is formed in the second polymer layer 120 to expose a central portion of the bump pad 210p. Preferably, for example, the second polymer layer 120 may comprise polyimide, PBO, phenolic resins, epoxy resins, or any suitable material having similar insulating and structural properties. Preferably, an island 120i of the second polymer layer 120 is disposed at a central portion of the bump pad 210p. Preferably, the island 120i of the second polymer layer 120 may be disposed directly above the RDL via 210v and the conductive pad 101.

Preferably, the island 120i acts as a stress buffer. Preferably, the island 120i has a width w3 that is greater than the width w2 of the RDL via 210v. Preferably, the width w3 of the island 120i may be smaller than the width w1 of the conductive pad 101.

Preferably, an under-bump metallization (UBM) layer 220 is formed on the bump pad 210p. Preferably, the UBM layer 220 covers the island 120i and may form a bulge 220b. Preferably, the UBM layer 220 may be a multi-layer stack including, but not limited to, an adhesion layer on the bump pad 210p, a barrier layer on the adhesion layer, and a seed layer on the barrier layer. For example, the adhesion layer may comprise Ti, TiN, or TiW. For example, the barrier layer may comprise Ni, Pt, Pd, or TiW. For example, the seed layer may comprise Cu, Ni, Au, or Al.

Preferably, a bump 250 is formed on the UBM layer 220 using suitable attachment, bonding, and re-flow processes. Preferably, for example, the bump 250 may comprise Sn, Al, Ni, Au, Ag, Pb, Bi, Cu, solder, or any combinations thereof. The island 120i under the bump 250 is provided to relieve the stress at the interface between the conductive pad 101 and the RDL via 210v.

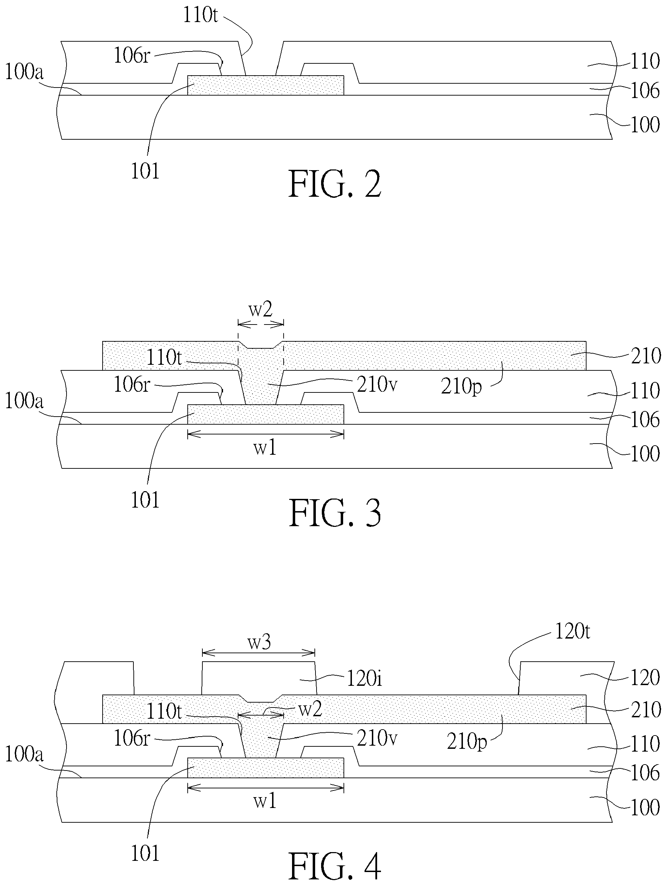

FIG. 2 to FIG. 5 are schematic, cross-sectional diagrams showing an exemplary method for manufacturing the bump structure in FIG. 1. As shown in FIG. 2, a semiconductor die 100 is provided. At least one conductive pad 101 may be disposed on an active top surface 100a of a semiconductor die 100. Preferably, the conductive pad 101 may comprise an aluminum pad, but is not limited thereto. Preferably, the perimeter of the conductive pad 101 is covered with a passivation layer 106. Preferably, for example, the passivation layer 106 may comprise a silicon nitride layer, but is not limited thereto. An opening 106r is then formed in the passivation layer 106 to expose a central portion of the conductive pad 101.

Subsequently, a first polymer layer 110 is formed on the passivation layer 106 and in the opening 106r. For example, the first polymer layer 110 may be formed by using spin coating, deposition, or any suitable method known in the art. Preferably, for example, the first polymer layer 110 may comprise polyimide, PBO, phenolic resins, epoxy resins, or any suitable material having similar insulating and structural properties. Preferably, a via opening 110t is then formed in the first polymer layer 110 to expose a central portion of the conductive pad 101.

As shown in FIG. 3, a re-distribution layer (RDL) 210 is formed on the first polymer layer 110 and is patterned into a bump pad 210p situated directly above the conductive pad 101. Preferably, the via opening 110t is completely filled with the RDL 210 and a RDL via 210v is integrally formed with the bump pad 210p. Preferably, for example, the RDL 210 may comprise copper. Preferably, the RDL via 210v has a width w2 that is smaller than a width w1 of the conductive pad 101.

As shown in FIG. 4, a second polymer layer 120 is formed on the first polymer layer 110 and covers the perimeter of the bump pad 210p. An opening 120t is formed in the second polymer layer 120 to expose a central portion of the bump pad 210p. Preferably, for example, the second polymer layer 120 may comprise polyimide, PBO, phenolic resins, epoxy resins, or any suitable material having similar insulating and structural properties. For example, the second polymer layer 120 may be formed by using spin coating, deposition, or any suitable method known in the art.

Preferably, an island 120i of the second polymer layer 120 of the second polymer layer 120 is disposed at a central portion of the bump pad 210p. Preferably, the island 120i of the second polymer layer 120 may be disposed directly above the RDL via 210v and the conductive pad 101.

Preferably, the island 120i acts as a stress buffer. Preferably, the island 120i has a width w3 that is greater than the width w2 of the RDL via 210v. Preferably, the width w3 of the island 120i may be smaller than the width w1 of the conductive pad 101.

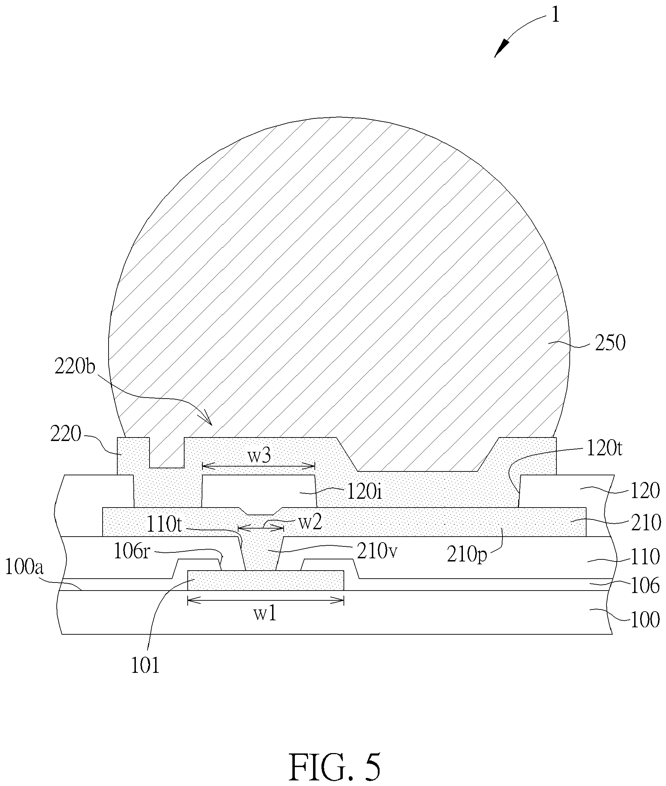

As shown in FIG. 5, a UBM layer 220 is then formed on the bump pad 210p. Preferably, the UBM layer 220 covers the island 120i and may form a bulge 220b. Preferably, the UBM layer 220 may be a multi-layer stack including, but not limited to, an adhesion layer on the bump pad 210p, a barrier layer on the adhesion layer, and a seed layer on the barrier layer. For example, the adhesion layer may comprise Ti, TiN, or TiW. For example, the barrier layer may comprise Ni, Pt, Pd, or TiW. For example, the seed layer may comprise Cu, Ni, Au, or Al.

Preferably, a bump 250 is formed on the UBM layer 220 using suitable attachment, bonding, and re-flow processes. Preferably, for example, the bump 250 may comprise Sn, Al, Ni, Au, Ag, Pb, Bi, Cu, solder, or any combinations thereof. The island 120i under the bump 250 is provided to relieve the stress at the interface between the conductive pad 101 and the RDL via 210v.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A bump structure (1), comprising:
a conductive pad (101) disposed on an active top surface (100a) of a semiconductor die (100);
a passivation layer (106) covering a perimeter of the conductive pad (101), wherein the passivation layer (106) comprises an opening (106r) exposing a central portion of the conductive pad (101);
a first polymer layer (110) disposed on the passivation layer (106) and in the opening (106r), wherein the first polymer layer (110) comprises a via opening (110t) partially exposing the central portion of the conductive pad (101);
a re-distribution layer, in the following also referred to as RDL, (210) disposed on the first polymer layer (110) and patterned into a bump pad (210p) situated directly above the conductive pad (101), wherein the via opening (110t) is completely filled with the RDL (210) and a RDL via (210v) is integrally formed with the bump pad (210p);
a second polymer layer (120) disposed on the first polymer layer (110), wherein the second polymer layer (120) covers a perimeter of the bump pad (210p);
an island (120i) of the second polymer layer (120) disposed at a central portion of the bump pad (210p);
an under-bump metallization, in the following also referred to as UBM, layer (220) disposed on the bump pad (210p), wherein the UBM layer (220) covers the island (120i) and forms a bulge (220b) thereon; and
a bump (250) disposed on the UBM layer (220).

2. A method for forming a bump structure (1), comprising:
forming a conductive pad (101) on an active top surface (100a) of a semiconductor die (100);
forming a passivation layer (106) covering a perimeter of the conductive pad (101), wherein the passivation layer (106) comprises an opening (106r) exposing a central portion of the conductive pad (101);
forming a first polymer layer (110) on the passivation layer (106) and in the opening (106r), wherein the first polymer layer (110) comprises a via opening (110t) partially exposing the central portion of the conductive pad (101);
forming a re-distribution layer, in the following also referred to as RDL, (210) on the first polymer layer (110) and patterned into a bump pad (210p) situated directly above the conductive pad (101), wherein the via opening (110t) is completely filled with the RDL (210) and a RDL via (210v) is integrally formed with the bump pad (210p);
forming a second polymer layer (120) on the first polymer layer (110), wherein the second polymer layer (120) covers a perimeter of the bump pad (210p);
forming an island (120i) of the second polymer layer (120) at a central portion of the bump pad (210p);
forming an under-bump metallization, in the following also referred to as UBM, layer (220) on the bump pad (210p), wherein the UBM layer (220) covers the island (120i) and forms a bulge (220b) thereon; and
forming a bump (250) on the UBM layer (220).

3. The bump structure (1) according to claim 1 or the method according to claim 2, wherein the conductive pad (101) comprises an aluminum pad.

4. The bump structure (1) according to claim 1 or 3, or the method according to claim 2 or 3, wherein the passivation layer (106) comprises a silicon nitride layer.

5. The bump structure (1) according to claim 1, 3 or 4, or the method according to any one of claims 2 to 4, wherein the first polymer layer (110) comprises polyimide, PBO, phenolic resins, or epoxy resins.

6. The bump structure (1) according to any one of claims 1 and 3 to 5, or the method according to any one of claims 2 to 5, wherein the second polymer layer (120) comprises polyimide, PBO, phenolic resins, or epoxy resins.

7. The bump structure (1) according to any one of claims 1 and 3 to 6, or the method according to any one of claims 2 to 6, wherein the RDL (210) comprises copper.

8. The bump structure (1) according to any one of claims 1 and 3 to 7, or the method according to any one of claims 2 to 7, wherein the RDL via (210v) has a width (w2) that is smaller than a width (w1) of the conductive pad (101).

9. The bump structure (1) according to any one of claims 1 and 3 to 8, or the method according to any one of claims 2 to 8, wherein the island (120i) of the second polymer layer (120) is disposed directly above the RDL via (210v) and the conductive pad (101).

10. The bump structure (1) according to any one of claims 1 and 3 to 9, or the method according to any one of claims 2 to 9, wherein the island (120i) of the second polymer layer (120) has a width (w3) that is greater than a width (w2) of the RDL via (210v).

11. The bump structure (1) according to any one of claims 1 and 3 to 10, or the method according to any one of claims 2 to 10, wherein the island (120i) of the second polymer layer (120) has a width (w3) that is smaller than a width (w1) of the conductive pad (101).

12. The bump structure (1) according to any one of claims 1 and 3 to 11, or the method according to any one of claims 2 to 11, wherein the UBM layer (220) is a multi-layer stack comprising an adhesion layer on the bump pad (210p), a barrier layer on the adhesion layer, and a seed layer on the barrier layer.

13. The bump structure (1) according to any one of claims 1 and 3 to 12, or the method according to any one of claims 2 to 12, wherein the bump (250) comprises Sn, Al, Ni, Au, Ag, Pb, Bi, Cu, solder, or any combinations thereof.
